# EUROPÄISCHE PATENTSCHRIFT

(11) **EP 2 567 264 B1**
(45) Veröffentlichungstag und Bekanntmachung des Hinweises auf die Patenterteilung: **11.06.2014**
(21) Anmeldenummer: 11716213.1
(22) Anmeldetag: 15.04.2011
(51) Int. Cl.: G01V 3/10

(54) **ERFASSUNG EINES METALLISCHEN ODER MAGNETISCHEN OBJEKTS**
DETECTION OF A METAL OR MAGNETIC OBJECT
DÉTECTION D'UN OBJET MÉTALLIQUE OU MAGNÉTIQUE

(30) Priorität: 07.05.2010 DE 102010028721; 09.07.2010 DE 102010031147
(43) Veröffentlichungstag der Anmeldung: 13.03.2013
(73) Patentinhaber: Robert Bosch GmbH, 70442 Stuttgart (DE)
(72) Erfinder: ZIBOLD, Tobias, 70567 Stuttgart (DE); ALBRECHT, Andrej, 70567 Stuttgart (DE)
(86) Internationale Anmeldenummer: PCT/EP2011/056025
(87) Internationale Veröffentlichungsnummer: WO 2011/138151

(56) Entgegenhaltungen:
- JP-A- 2005 140 747
- US-A- 4 611 169
- US-A1- 2003 184 301
- US-A1- 2006 238 199
- US-A1- 2007 046 288

## Beschreibung

Bei bestimmten Bearbeitungen von Werkstücken besteht die Gefahr, dass ein im Werkstück verborgener Gegenstand durch die Bearbeitung beschädigt wird. Beispielsweise kann beim Bohren in eine Wand eine Wasser-, Strom- oder Gasleitung beschädigt werden, die innerhalb der Wand verläuft. Im umgekehrten Fall kann es wünschenswert sein, die Bearbeitung gerade so durchzuführen, dass ein im Werkstück verborgener Gegenstand mitbearbeitet wird, beispielsweise wenn das Loch aus dem obigen Beispiel durch ein Armierungseisen oder eine tragende Konstruktion innerhalb der Wand verlaufen soll.

### Stand der Technik

Zur Erfassung eines solchen verborgenen Gegenstandes sind spulenbasierte Metalldetöktören im Stand der Technik bekannt. Deartige Detektoren erzeugen ein magnetisches Feld in einem Messbereich. Befindet sich ein metallischer Gegenstand im Messbereich, so wird der Gegenstand aufgrund seiner Beeinflussung des erzeugten magnetischen Feldes erkannt. Häufig werden zur Bestimmung des erzeugten Magnetfeldes wenigstens zwei Empfangsspulen verwendet, die derartig orientiert und miteinander verbunden sind, dass in Abwesenheit eines metallischen Objekts im Messbereich das von beiden Empfangsspulen gemeinsam gelieferte Messsignal gegen Null geht (differentielle Messung). In einer Variante werden mehrere Sendespulen zur Erzeugung des Magnetfeldes verwendet, die so angesteuert werden, dass unabhängig von einer Anwesenheit eines metallischen Objekts im Messbereich das in den beiden Empfangsspulen gemessene Signal gegen Null geht (feldkompensierte Messung).

DE 10 2007 053 881 A1 beschreibt ein Messverfahren zur Bestimmung der Position bzw. des Winkels einer Spule bezüglich zweier weiterer Spulen. Dazu wird mittels zweier winklig zueinander angeordneter Sendespulen ein magnetisches Wechselfeld generiert. Eine Empfangsspule wird in das magnetische Wechselfeld verbracht und die Ansteuerung der Sendespulen derart verändert, dass in der Empfangsspule von jeder der Sendespulen die gleiche Spannung induziert wird. Ein Verhältnis von den Sendespulen zugeführten Stromwerten dient als Maß für eine Positions- und/oder Winkelbestimmung der Empfangsspule bezüglich der Sendespulen.

Ein Metallsuchgerät mit Printspulen wird in der DE 10 2004 047 189 A1 offenbart.

US 2006/0238199 A1, US 4,611,169, US 2003/0184301 A1 und JP 2005140747 offenbaren weitere Metalldetektoren mit zwei oder mehr Sendespulen wobei eine Steuereinrichtung die Sendespulen mit Spannungen versorgt, derart dass die Spannung in einer Empfangsspule minimiert ist.

Der Erfindung liegt die Aufgabe zugrunde, einen einfachen und genauen Detektor für ein metallisches Objekt bereitzustellen. Eine weitere Aufgabe der Erfindung besteht in der Angabe eines Verfahrens zur Bestimmung des metallischen Objekts.

### Offenbarung der Erfindung

Die Erfindung löst diese Aufgaben mittels einer Messvorrichtung mit den Merkmalen des Anspruchs 1 und eines Verfahrens mit den Merkmalen des Anspruchs 9. Unteransprüche geben bevorzugte Ausführungsformen an.

Erfindungsgemäß umfasst eine Messvorrichtung zur Erfassung eines metallischen Objekts zwei Sendespulen zur Erzeugung überlagerter Magnetfelder, eine Empfangsspule im Bereich der beiden Magnetfelder und eine Steuereinrichtung zur Versorgung der Sendespulen mit alternierenden Spannungen derart, dass eine zu den alternierenden Spannungen taktsynchrone Wechselspannung, die in der Empfangsspule induziert wird, betragsmäßig minimiert ist. Dabei ist die Steuereinrichtung dazu eingerichtet, das metallische Objekt zu erfassen, wenn das Verhältnis der alternierenden Spannungen nicht zum Verhältnis der Abstände der Empfangsspule zu den Sendespulen korrespondiert.

Wird das System durch ein metallisches Objekt gestört, so wird in der Empfangsspule eine zu den alternierenden Spannungen taktsynchrone Wechselspannung induziert. Das Regelsystem ist dahingehend ausgelegt, diesen taktsynchronen Wechselspannungsanteil betragsmäßig zu minimieren (d. h. zu Null zu machen). Gleichspannungsanteile, oder auch nicht taktsynchrone Wechselspannungsanteile durch Fremdeinkopplung bleiben unberücksichtigt. Dadurch kann vorteilhafterweise eine Störanfälligkeit der Messvorrichtung reduziert sein.

Vorteilhafterweise ist es so unter Verwendung von nur drei Spulen möglich, sowohl differentiell als auch feldkompensiert zu messen. Dadurch kann bei hoher Sensitivität der Messvorrichtung ein Herstellungsaufwand verringert sein, womit Kostenvorteile verbunden sein können.

Vorzugsweise sind die alternierenden Spannungen zueinander phasenverschobene Wechselspannungen, um die Magnetfelder der Sendespulen periodisch in Betrag und Phase zu ändern. Die Wechselspannungen ermöglichen die Synchrondemodulation, womit störende Signale mit Frequenzen ungleich der Modulationsfrequenz sehr effektiv unterdrückt werden können. Darüber hinaus können durch die Wechselspannungen wechselnde Magnetfelder erzeugt werden, um Wirbelströme in nichtmagnetischen Materialien wie z.B. Kupfer zu induzieren, aufgrund derer diese dann detektiert werden können.

Die Empfangsspule kann symmetrisch zwischen den Sendespulen angeordnet sein. Dadurch kann je nach Annäherungsrichtung des metallischen Objekts das Vorzeichen des Messwertes unterschiedlich sein und auf der Grundlage des Vorzeichens kann eine Entscheidung getroffen werden, ob auf das Objekt reagiert wird oder nicht. Fehlmessungen können auf diese Weise vermieden werden.

Im Bereich der Magnetfelder der Sendespulen kann auch eine weitere Empfangsspule angeordnet sein, wobei die Steuereinrichtung dazu eingerichtet ist, die Versorgung der Sendespulen mit Spannung alternierend auf der Basis der in der Empfangsspule und der in der weiteren Empfangsspule induzierten Spannung durchzuführen.

Die Empfangsspule und die weitere Empfangsspule können unterschiedliche Positionen bezüglich der Sendespulen einnehmen und/oder aufgrund ihrer Form, Ausdehnung oder ihres Aufbaus unterschiedliche Sensitivitäten haben. Bei entsprechendem Aufbau und Anordnung der Sende- und Empfangsspulen kann es somit möglich sein, eine Richtung, eine Entfernung und/oder eine Größe des metallischen Objekts durch vergleichende Messungen mit den mehreren Empfangsspulen zu bestimmen.

Obwohl beliebige Spulentypen verwendet werden können, ist bevorzugterweise wenigstens eine der Spulen eine Luftspule. Dadurch kann die Messeinrichtung so aufgebaut sein, dass sie auf Temperatur- oder Alterungseinflüsse nur sehr schwach reagiert, wodurch eine Kalibrierung einmalig im Rahmen einer Herstellung der Messvorrichtung erfolgen kann.

Vorzugsweise ist wenigstens eine der Spulen als gedruckte Schaltung ("Printspule") auf einer Platine ausgebildet. Dadurch kann eine präzise Fertigung der einen oder mehreren Printspulen bei geringem Produktionsaufwand realisiert sein. Dabei kann die Steuereinrichtung auf derselben Platine aufgebaut sein. Durch Minimierung von Verdrahtungs- und Bestückungskosten können so weitere Herstellungskosten eingespart werden.

Es ist auch denkbar, die Empfangsspule durch einen Magnetfeldsensor zu ersetzen. Beispielsweise kann ein magnetoresistiver Magnetfeldsensor wie etwa ein Hall-Sensor verwendet werden.

Nach einem weiteren Aspekt der Erfindung umfasst ein Verfahren zur Erfassung eines metallischen Objekts die Schritte des Erzeugens überlagerter Magnetfelder mittels zweier Sendespulen, des Bestimmens einer in einer Empfangsspule im Bereich der beiden Magnetfelder induzierten Spannung, des Versorgens der Sendespulen mit alternierenden Spannungen derart, dass eine zu den alternierenden Spannungen taktsynchrone Wechselspannung, die in der Empfangsspule induziert wird, betragsmäßig minimiert ist, und des Erfassens des metallischen Objekts, wenn das Verhältnis der alternierenden Spannungen nicht zum Verhältnis der Abstände der Empfangsspule zu den Sendespulen korrespondiert.

Die Erfindung kann auch als Computerprogrammprodukt ausgeführt sein, wobei ein erfindungsgemäßes Computerprogrammprodukt Programmcodemittel zur Durchführung des beschriebenen Verfahrens umfasst und auf einer Verarbeitungseinrichtung ablaufen oder auf einem computerlesbaren Datenträger gespeichert sein kann.

### Kurze Beschreibung der Figuren

Im Folgenden wird die Erfindung mit Bezug auf die beigefügten Figuren genauer beschrieben, in denen:
- Figur 1: ein Blockschaltbild einer Messvorrichtung;
- Figur 2: eine Anordnung von Spulen und eines metallischen Objekts an der Messvorrichtung aus Figur 1;
- Figur 3: eine Anordnung mehrerer Empfangsspulen für die Messvorrichtung aus Figur 1; und
- Figur 4: ein Ablaufdiagramm eines Verfahrens für die Messeinrichtung aus Figur 1
darstellt.

### Genaue Beschreibung von Ausführungsbeispielen

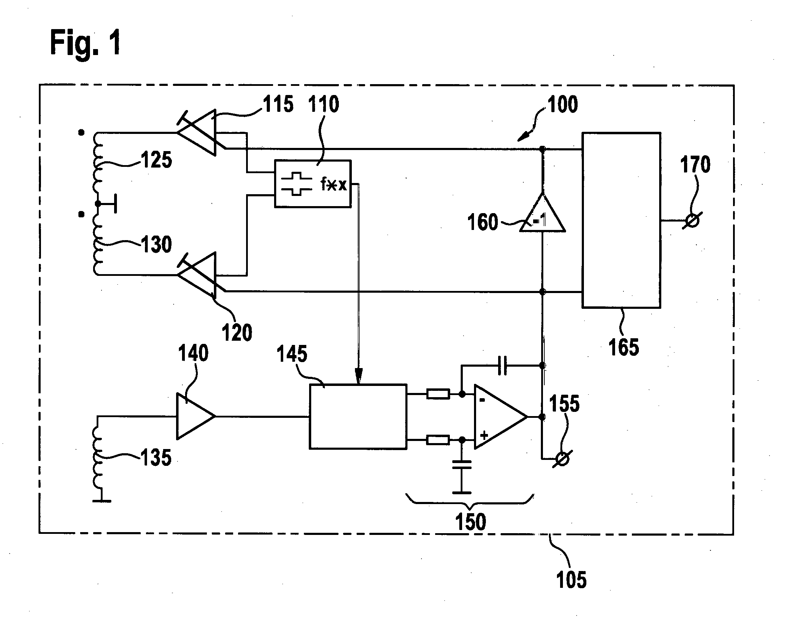

Figur 1 zeigt ein Blockschaltbild einer Messvorrichtung 100. Die Messvorrichtung 100 ist Teil eines Metalldetektors 105 zum Erfassen metallischer Objekte, beispielsweise aus eisenhaltigem Material.

Ein Taktgenerator 110 hat zwei Ausgänge, an denen er phasenverschobene, vorzugsweise um 180° phasenverschobene, periodische Wechselsignale bereitstellt. Die Wechselsignale können insbesondere Rechteck-, Dreieck- oder Sinussignale umfassen. Die Ausgänge des Taktgenerators sind mit einem ersten steuerbaren Verstärker 115 bzw. einem zweiten steuerbaren Verstärker 120 verbunden. Jeder der steuerbaren Verstärker 115, 120 verfügt über einen Steuereingang, über den er ein Signal entgegennimmt, welches einen Verstärkungsfaktor des steuerbaren Verstärkers 115, 120 steuert. Ein Ausgang des ersten steuerbaren Verstärkers 115 ist mit einer ersten Sendespule 125 und ein Ausgang des zweiten steuerbaren Verstärkers 120 mit einer zweiten Sendespule 130 verbunden. Verbleibende Enden der Sendespulen 125 und 130 sind jeweils elektrisch mit Masse verbunden.

Wie durch die Punkte an den Sendespulen 125 und 130 angedeutet ist, sind die Sendespulen 125 und 130 gleichsinnig orientiert. Bei Versorgung mit bezüglich Masse entgegengesetzten Spannungen bauen die Sendespulen 125, 130 magnetische Felder mit entgegengesetzten Ausrichtungen auf. Im objektfreien Fall und bei symmetrischer Anordnung der Empfangsspule 135 zwischen den Sendespulen 125 und 130 ist der magnetische Fluss, der die Empfangsspule 135 durchsetzt Null und ebenso ist die in der Empfangsspule 135 induzierte Spannung Null. Der gleiche Effekt kann auch durch entsprechendes Umorientieren der Sendespulen 125, 130 und Anpassen der Polaritäten der von den steuerbaren Verstärkern 115, 120 abgegebenen Spannungen erzielt werden.

Das Messprinzip kann in nicht weniger vorteilhafter Weise umgesetzt werden, wenn die Sendespulen mit Spannungen versorgt werden, die bezogen auf Masse die gleiche Polarität aufweisen. Während bei Versorgung mit Spannungen entgegengesetzter Polarität bei symmetrischer Anordnung der Empfangsspule 135 zwischen den Sendespulen 125 und 130 im objektfreien Fall die an den Sendespulen 125, 130 anliegenden Spannungen während einer Halbwelle näherungsweise dieselbe Amplitude haben, ist dies bei Versorgung mit Spannungen gleicher Polarität nicht erforderlich. Vielmehr ist auch denkbar, dass bei Versorgung mit Spannungen gleicher Polarität sich die Amplituden der an den Sendespulen 125, 130 anliegenden Spannungen während einer Halbwelle bereits im objektfreien Fall und symmetrischer Anordnung der Empfangsspule 135 zwischen den Sendespulen 125, 130 unterscheiden. In der darauffolgenden Halbwelle liegen diese Amplituden dann an der jeweils anderen Sendespule 130, 125 an. In Anwesenheit eines metallischen Objektes unterscheiden sich dagegen die Amplituden an der jeweils anderen Sendespule 130, 125 auch in aufeinanderfolgenden Halbwellen. In diesem Fall sind die Sendespulen 125, 130 gleichsinnig zu orientieren, so dass von den beiden Sendespulen 125, 130 gleich gerichtete Magnetfelder aufgebaut werden. Damit ist der magnetische Fluss, der die Empfangsspule 135 durchsetzt, zeitlich konstant und die in der Empfangsspule 135 induzierte Spannung ist Null.

Die weitere Beschreibung bezieht sich auf das Ausführungsbeispiele mit entgegengesetzter Polarität der Versorgungsspannungen und gleichsinniger Orientierung der Sendespulen 125, 130.

Eine Empfangsspule 135 ist mit einem Anschluss mit Masse verbunden, der zweite Anschluss führt zu einem Eingangsverstärker 140. In einer weiteren Ausführungsform kann die Empfangsspule 135 durch einen Magnetfeldsensor ersetzt werden, beispielsweise einen Hall-Sensor. Die Empfangsspule kann mit ihren Enden auch mit den beiden Eingängen eines Differenzverstärkers verbunden sein, wobei der Ausgang des Differenzverstärkers mit dem Eingangsverstärker 140 verbunden ist. Der Eingangsverstärker 140 ist mit einem konstanten Verstärkungsfaktor dargestellt; in anderen Ausführungsformen kann jedoch ein Verstärkungsfaktor des Eingangsverstärkers 140 auch steuerbar sein. Dadurch kann beispielsweise eine räumliche Auflösung und/oder Empfindlichkeit der Messvorrichtung 100 beeinflussbar und beispielsweise in Abhängigkeit einer Messgröße steuerbar sein.

Der Ausgang des Eingangsverstärkers 140 ist mit einem Synchrondemodulator 145 verbunden. Der Synchrondemodulator 145 ist ferner mit dem Taktgenerator 110 verbunden und empfängt von diesem ein Taktsignal, welches auf die Phasenlage der an den Ausgängen des Taktgenerators 110 bereitgestellten Signale hinweist. In einer einfachen Ausführungsform, bei der die vom Taktgenerator 110 bereitgestellten Signale symmetrische Rechtecksignale sind, kann eines der Ausgangssignale als Taktsignal verwendet werden. Der Synchrondemodulator 145 schaltet im Wesentlichen auf der Basis des vom Taktgenerator 110 bereitgestellten Taktsignals das vom Eingangsverstärker 140 empfangene Messsignal alternierend an seinem oberen bzw. unteren Ausgang durch.

Die beiden Ausgänge des Synchrondemodulators 145 sind mit einem Integrator (integrierenden Komparator) 150 verbunden, der hier als mit zwei Widerständen und zwei Kondensatoren beschalteter Operationsverstärker dargestellt ist. Andere Ausführungsformen sind ebenfalls möglich, beispielsweise als aktiver Tiefpass. Auch eine digitale Ausführung im Anschluss an den Synchrondemodulator 145 ist denkbar, bei der das Signal am Ausgang des Synchrondemodulators 145 zu einem/mehreren Zeitpunkt(en) innerhalb einer Halbwelle analog zu digital gewandelt wird und dann mit dem entsprechenden Wert aus der nächsten Halbwelle verglichen wird. Die Differenz wird integriert und z.B. wieder in ein analoges Signal überführt und zur Steuerung der Verstärker verwendet. Während der Synchrondemodulator 145 das vom Eingangsverstärker 140 empfangene Messsignal am unteren seiner Ausgänge bereitstellt, integriert der Integrator 150 dieses Signal über die Zeit und stellt das Resultat an seinem Ausgang bereit. Während der Synchrondemodulator 145 das vom Eingangsverstärker 140 empfangene Messsignal an seinem oberen Ausgang bereitstellt, wird dieses vom Integrator 150 invertiert über die Zeit integriert und das Resultat am Ausgang des Integrators 150 bereitgestellt. Die Spannung am Ausgang des Integrators 150 ist das Integral der Differenz der tiefpassgefilterten Ausgänge des Synchrondemodulators.

Der Synchrondemodulator berücksichtigt nur induzierte Spannungen, die zu den alternierenden Spannungen der steuerbaren Verstärker 115, 120 taktsynchron sind. Gleichspannungsanteile oder auch nicht taktsynchrone Wechselspannungsanteile der induzierten Spannung bleiben unberücksichtigt, weshalb die Messvorrichtung gegenüber derartigen Störungen resistent ist. Wird in der Empfangsspule 135 vom Magnetfeld der ersten Sendespule 125 eine genauso große Spannung induziert wie vom Magnetfeld der zweiten Spule 130, so sind die an den Ausgängen des Synchrondemodulators 145 bereitgestellten Signale im Mittel über die Zeit gleich groß und am Ausgang des Integrators 150 wird ein Signal bereitgestellt, das gegen Null (Masse) geht. Überwiegt jedoch der Einfluss des Magnetfeldes einer der Sendespulen 125, 130, so sind die an den Ausgängen des Synchrondemodulators 145 bereitgestellten Signale im Mittel nicht mehr gleich, und am Ausgang des Integrators 150 wird ein positives oder negatives Signal bereitgestellt.

Die in der Empfangsspule 135 induzierte Spannung wird durch ungleiche Abstände der Empfangsspule 135 zu den Sendespulen 125, 130 beeinflusst. Eine entsprechende Beeinflussung entsteht durch ungleiche Amplituden der von den Sendespulen 125, 130 abgegebenen Spannungen. Da die Position der Empfangsspule 135 invariant gegenüber den Sendespulen 125, 130 ist, entspricht ein vorbestimmtes Verhältnis zwischen den Amplituden der von den steuerbaren Verstärkern 115, 120 abgegebenen Spannungen dem objektfreien Fall. Unterscheidet sich das Verhältnis der Spannungen vom vorbestimmten Verhältnis, kann auf das Objekt im Bereich der überlagerten Magnetfelder der Sendespulen 125, 130 geschlossen werden.

Das vom Integrator 150 bereitgestellte Signal wird über einen Anschluss 155 zur weiteren Verarbeitung bereitgestellt. Zusätzlich kann ein Mikrocomputer 175 mit den Steuereingängen der steuerbaren Verstärker 115, 120 verbunden sein. Der Mikrocomputer 175 führt einen Vergleich des bereitgestellten Signals mit einem Schwellenwert durch und gibt an einem Ausgang 180 ein Signal aus, welches auf das metallische Objekt hinweist. Das Signal kann in optischer und/oder akustischer Weise einem Benutzer des Metalldetektors 105 dargeboten werden.

Der Mikrocomputer 175 kann darüber hinaus eine weitere Verarbeitung der von den Steuereingängen der steuerbaren Verstärker 115, 120 abgegriffenen Signale durchführen und in deren Abhängigkeit Parameter der Messvorrichtung 100 steuern. Beispielsweise kann eine Frequenz oder Signalform der alternierenden Spannungen an den Ausgängen des Taktgenerators 110 variiert oder eine Empfindlichkeit des Empfangsverstärkers 140 geändert werden. In einer weiteren Ausführungsform sind weitere der gezeigten Elemente der Messvorrichtung 100 durch den Mikrocomputer 175 implementiert, etwa der Taktgenerator 110, der Synchrondemodulator 145 oder der Integrator 150.

Das gleiche Signal des Integrators 150 wird auch zur Steuerung der Verstärkungsfaktoren der steuerbaren Verstärker 115 und 120 verwendet, wobei der zweite steuerbare Verstärker 120 unmittelbar mit dem Ausgang des Integrators 150 verbunden ist und der erste steuerbare Verstärker 115 mittels eines Inverters 160 mit dem Ausgang des Integrators 150 verbunden ist. Der Inverter 160 bewirkt eine Umkehrung des ihm bereitgestellten Signals derart, dass in Abhängigkeit des Ausgangssignals des Integrators 150 der Verstärkungsfaktor des ersten steuerbaren Verstärkers 115 in dem Maß zunimmt wie der Verstärkungsfaktor des zweiten steuerbaren Verstärkers 120 abnimmt bzw. umgekehrt. Es ist auch denkbar, dass nur der Verstärkungsfaktor eines der beiden steuerbaren Verstärker 115, 120 gesteuert wird, während der Verstärkungsfaktor des zweiten steuerbaren Verstärkers 115, 120 auf einem festen Wert gehalten wird.

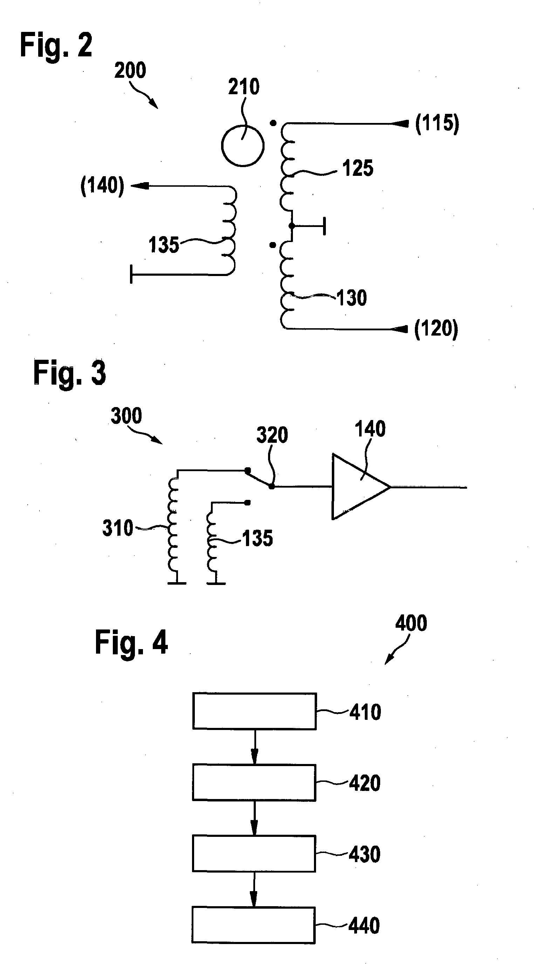

Figur 2 zeigt eine Anordnung 200 der Sendespulen 125, 130 und der Empfangsspule 135 bezüglich eines metallischen Objekts 210 zur Erläuterung des Messprinzips der Messvorrichtung 100 aus Figur 1. Die Sendespulen 125 und 130 sind derart zueinander ausgerichtet, dass die Richtungen ihrer Hauptmagnetfelder miteinander fluchten, wobei die Sendespulen 125, 130 einen gewissen Abstand aufweisen. Im Fall von Sendespulen 125, 130, deren Durchmesser wesentlich größer als ihre Länge ist, beispielsweise wenn die Sendespulen 125, 130 als Printspulen ausgeführt sind, können die Sendespulen 125, 130 in zueinander parallelen Ebenen liegen, im Beispiel der Printspulen etwa auf gegenüberliegenden Oberflächen einer Platine.

Wie oben mit Bezug auf Figur 1 beschrieben ist, sind die Sendespulen 125, 130 derart angeordnet und miteinander verbunden, dass sie in Abhängigkeit der vom Taktgenerator 110 bereitgestellten Signale alternierende Magnetfelder generieren, wobei zu jedem Zeitpunkt das Magnetfeld der ersten Sendespule 125 entgegengesetzt zum Magnetfeld der zweiten Sendespule 130 ausgerichtet ist. Auf einer Fläche zwischen den Sendespulen 125 und 130 heben sich die überlagerten magnetischen Felder gegenseitig auf. Die Empfangsspule 135 ist in dieser Fläche angeordnet, wobei eine Achse, um die die Empfangsspule 135 gewickelt ist, bevorzugterweise auf der Fläche senkrecht steht. Die Empfangsspule 135 kann mit den Sendespulen 125, 130 fluchten oder seitlich verschoben zu den Sendespulen 125, 130 angeordnet sein. Fluchten die Sendespulen 125, 130 miteinander, so ist die Fläche eine Ebene.

Ein metallisches Objekt 210 befindet sich im Bereich der magnetischen Felder der Sendespulen 125 und 130, wobei ein Abstand des metallischen Objekts 210 zur ersten Sendespule 125 geringer als zur zweiten Sendespule 130 ist. Das magnetische Feld der ersten Sendespule 125 wird also durch das metallische Objekt 210 stärker beeinflusst als das Magnetfeld der zweiten Sendespule 130. Dementsprechend ist die Empfangsspule 135 Magnetfeldern der Sendespulen 125, 130 ausgesetzt, die ungleich stark sind, so dass ein resultierendes Magnetfeld im Bereich der Empfangsspule 135 besteht und in der Empfangsspule 135 eine positive Spannung induziert wird. Befindet sich das metallische Objekt 210 näher an der zweiten Sendespule 130 als an der ersten Sendespule 125, so ist die Differenzspannung dementsprechend negativ.

Der Betrag der in der Empfangsspule 135 induzierte Spannung hängt von der Asymmetrie der auf die Empfangsspule 135 wirkenden magnetischen Felder der Sendespulen 125, 130 ab. Am Ausgang des Integrators 150 stellt sich daher ein Signal ein, das von der Asymmetrie der magnetischen Felder abhängt.

In Abhängigkeit der Ausgangsspannung des Integrators 150 werden die Verstärkungsfaktoren der steuerbaren Verstärker 115, 120 gegenläufig verändert, so dass die Sendespulen 125, 130 mit unterschiedlich großen Spannungen versorgt werden. Die von den Sendespulen 125, 130 generierten magnetischen Felder im Bereich der Empfangsspule 135 weisen dann wieder gleichen Betrag und unterschiedliches Vorzeichen auf, so dass die in der Empfangsspule 135 induzierte Spannung wieder gegen Null geht. Die Anwesenheit des metallischen Objekts 210 in den magnetischen Feldern ist durch die Abweichung des am Anschluss 155 anliegenden Regelsignals von Null erfassbar. In einer Ausführungsform werden metallische Objekte nur auf der Basis eines vorbestimmten Vorzeichens des Regelsignals erfasst. So werden Objekte auf einer Seite der Sendespulen 125, 130 ignoriert, die beispielsweise durch einen Benutzer der Messvorrichtung hervorgerufen sein können.

Figur 3 zeigt eine Anordnung 300 mehrerer Empfangsspulen für die Messvorrichtung 100 aus Figur 1. Zusätzlich zur Empfangsspule 135 ist eine weitere Empfangsspule 310 bereitgestellt. Ein Anschluss der weiteren Empfangsspule 310 ist mit Masse verbunden, der andere mit einem Schalter 320. Der Schalter 320 verbindet selektiv entweder den zweiten Anschluss der weiteren Empfangsspule 310 oder den zweiten Anschluss der Empfangsspule 135 mit dem Eingang des Eingangsverstärkers 140.

Die weitere Empfangsspule 310 hat mehr Windungen als die Empfangsspule 135 und liefert somit bei vergleichbarem Magnetfeld ein größeres Ausgangssignal als die Empfangsspule 135. Die Empfangsspulen 135 und 310 können beispielsweise nebeneinander oder konzentrisch angeordnet sein, beispielsweise als Printspulen.

In einer anderen Ausführungsform sind die Empfangsspulen 135 und 310 gleich aufgebaut. Durch Vorsehen entsprechend vieler weiterer Empfangsspulen 310 in Verbindung mit einem Schalter 320 mit einer passenden Anzahl Schaltstellungen kann je nach Anordnung der Empfangsspulen 135, 310 eine Richtung, eine Entfernung und/oder eine Größe des metallischen Objekts 210 bestimmbar sein, beispielsweise durch Triangulation auf der Basis einer Anordnung der Empfangsspulen 135, 310.

In einer Ausführungsform kann eine Vielzahl von gleichartigen Empfangsspulen 135, 310 in der oben mit Bezug auf Figur 2 beschriebenen Ebene angeordnet sein. Diejenige Empfangsspule 135, 310, die dem metallischen Objekt 210 am nächsten ist, erfordert die größte Asymmetrie der durch die Sendespulen 125, 130 erzeugten magnetischen Felder. Durch Umschalten mittels des Schalters 320 kann somit bestimmt werden, welche der Empfangsspulen 135, 310 dem metallischen Objekt 210 am nächsten ist, woraus eine Richtung des metallischen Objekts 210 bezüglich der Sendespulen 125, 130 abgeleitet werden kann.

Figur 4 zeigt eine schematisches Ablaufdiagramm eines Verfahrens 400 zur Erfassung eines metallischen Objekts 210 entsprechend der Messvorrichtung 100 aus Figuren 1 und 2. In einem Schritt 410 werden mittels der Sendespulen 125, 130 unterschiedlich orientierte magnetische Wechselfelder erzeugt. In einem Schritt 420 wird die in der Empfangsspule 135 induzierte Spannung bestimmt. In einem Schritt 430 werden in Abhängigkeit der im Schritt 420 bestimmten induzierten Spannung die Verstärkungsfaktoren der Verstärker 115, 120 derart gesteuert, dass die zu den alternierenden Spannungen taktsynchrone Spannung, die in der Empfangsspule 135 induziert wird, betragsmäßig minimiert ist. In einem abschließenden Schritt 440 wird das metallische Objekt 210 auf der Basis einer unsymmetrischen Versorgung der Sendespulen 125, 130 mit Spannung bzw. einer ungleichen Aussteuerung der Verstärker 115, 120 erfasst. Dazu wird verglichen, ob die am Anschluss 155 anliegende Spannung den Wert Null um mehr als ein vorbestimmtes Maß überschreitet, wobei dieses Maß selbst ein beliebiger Wert sein kann.

## Patentansprüche

1. Messvorrichtung (100) zur Erfassung eines metallischen Objekts (210), wobei die Messvorrichtung folgendes umfasst:
- zwei Sendespulen (125, 130) zur Erzeugung überlagerter Magnetfelder;
- eine Empfangsspule (135) im Bereich der beiden Magnetfelder;
- eine Steuereinrichtung (110-120, 145-160) zur Versorgung der Sendespulen (125, 130) mit alternierenden Spannungen derart, dass eine zu den alternierenden Spannungen taktsynchrone Spannung, die in der Empfangsspule (135) induziert wird, betragsmäßig minimiert ist,
**dadurch gekennzeichnet, dass**
- die Steuereinrichtung (110-120, 145-160) dazu eingerichtet ist, das metallische Objekt (210) zu erfassen, wenn das Verhältnis der alternierenden Spannungen nicht zum Verhältnis der Abstände der Empfangsspule (135) zu den Sendespulen (125, 130) korrespondiert.

2. Messvorrichtung (100) nach Anspruch 1, **dadurch gekennzeichnet, dass** die alternierenden Spannungen zueinander phasenverschobene Wechselspannungen sind, um die Magnetfelder der Sendespulen (125, 130) periodisch in Betrag und Phase zu ändern.

3. Messvorrichtung (100) nach Anspruch 1 oder 2, **dadurch gekennzeichnet, dass** die Empfangsspule (135) symmetrisch zwischen den Sendespulen (125, 130) angeordnet ist.

4. Messvorrichtung (100) nach Anspruch 3, **gekennzeichnet durch** wenigstens eine im Bereich der Magnetfelder der Sendespulen (125, 130) angeordnete weitere Empfangsspule (310), wobei die Steuereinrichtung (110-120, 145-160) dazu eingerichtet ist, die Versorgung der Sendespulen (125, 130) mit Spannung alternierend auf der Basis der in der Empfangsspule (135) und der in der weiteren Empfangsspule (310) induzierten Spannung durchzuführen.

5. Messvorrichtung (100) nach Anspruch 4, **dadurch gekennzeichnet, dass** eine Auswerteeinrichtung vorgesehen ist, um auf der Basis der in den Empfangsspulen (135, 310) induzierten Spannungen wenigstens eines von einer Richtung, einer Entfernung und einer Größe des metallischen Objekts (210) zu bestimmen.

6. Messvorrichtung (100) nach einem der vorangehenden Ansprüche, **dadurch gekennzeichnet, dass** wenigstens eine der Spulen (125, 130, 135) eine Luftspule ist.

7. Messvorrichtung (100) nach einem der vorangehenden Ansprüche, **dadurch gekennzeichnet, dass** wenigstens eine der Spulen (125, 130, 135) als gedruckte Schaltung auf einer Platine ausgebildet ist.

8. Messvorrichtung (100) nach Anspruch 7, **dadurch gekennzeichnet, dass** die Steuereinrichtung (110-120, 145-160) auf der Platine aufgebaut ist.

9. Verfahren (400) zur Erfassung eines metallischen Objekts (210), folgende Schritte umfassend:
- Erzeugen (410) überlagerter Magnetfelder mittels zweier Sendespulen (125, 130);
- Bestimmen (420) einer in einer Empfangsspule (135) im Bereich der beiden Magnetfelder induzierten Spannung;
- Versorgen (430) der Sendespulen (125, 130) mit alternierenden Spannungen derart, dass eine zu den alternierenden Spannungen taktsynchrone Spannung, die in der Empfangsspule (135) induziert wird, betragsmäßig minimiert ist, und
- Erfassen (440) des metallischen Objekts (210), wenn das Verhältnis der alternierenden Spannungen nicht zum Verhältnis der Abstände der Empfangsspule (135) zu den Sendespulen (125, 130) korrespondiert

10. Computerprogrammprodukt mit Programmcodemitteln zur Durchführung des Verfahrens nach Anspruch 9, wenn das Computerprogrammprodukt auf einer Verarbeitungseinrichtung abläuft oder auf einem computerlesbaren Datenträger gespeichert ist.

## Claims

1. Measuring device (100) for detecting a metallic object (210), wherein the measuring device comprises the following:
- two transmitting coils (125, 130) for generating superimposed magnetic fields;
- a receiving coil (135) in the area of the two magnetic fields;
- a control device (110-120, 145-160) for supplying the transmitting coils (125, 130) with alternating voltages in such a manner that the value of a voltage, which is clock-pulse synchronized with the alternating voltages and which is induced in the receiving coil (135), is minimized,
**characterized in that**
- the control device (110-120, 145-160) is configured for detecting the metallic object (210) when the ratio of the alternating voltages does not correspond to the ratio of the distances of the receiving coil (135) from the transmitting coils (125, 130).

2. Measuring device (100) according to Claim 1, **characterized in that** the alternating voltages are mutually phase-shifted alternating voltages for changing the magnetic fields of the transmitting coils (125, 130) periodically in value and phase.

3. Measuring device (100) according to Claim 1 or 2, **characterized in that** the receiving coil (135) is arranged symmetrically between the transmitting coils (125, 130).

4. Measuring device (100) according to Claim 3, **characterized by** at least one further receiving coil (310) arranged in the area of the magnetic fields of the transmitting coils (125, 130), the control device (110-120, 145-160) being configured for supplying the transmitting coils (125, 130) with voltage alternatingly on the basis of the voltage induced in the receiving coil (135) and of the voltage induced in the further receiving coil (310).

5. The measuring device (100) according to Claim 4, **characterized in that** an evaluating device is provided for determining on the basis of the voltages induced in the receiving coils (135, 310) at least one of a direction, a distance and a size of the metallic object (210).

6. Measuring device (100) according to one of the preceding claims, **characterized in that** at least one of the coils (125, 130, 135) is an air-core coil.

7. Measuring device (100) according to one of the preceding claims, **characterized in that** at least one of the coils (125, 130, 135) is constructed as printed circuit on a printed circuit board.

8. Measuring device (100) according to Claim 7, **characterized in that** the control device (110-120, 145-160) is constructed on the printed circuit board.

9. Method (400) for detecting a metallic object (210), comprising the following steps:
- generating (410) superimposed magnetic fields by means of two transmitting coils (125, 130);
- determining (420) a voltage induced in a receiving coil (135) in the area of the two magnetic fields;
- supplying (430) the transmitting coils (125, 130) with alternating voltages in such a manner that the value of a voltage, which is clock-pulse synchronized with the alternating voltages and which is induced in the receiving coil (135), is minimized, and
- detecting (440) the metallic object (210) when the ratio of the alternating voltages does not correspond to the ratio of the distances of the receiving coil (135) from the transmitting coils (125, 130).

10. Computer program product comprising program code means for performing the method according to Claim 9 when the computer program product runs on a processing device or is stored on a computer-readable data medium.

## Revendications

1. Dispositif de mesure (100) servant à détecter un objet métallique (210), le dispositif de mesure présentant :
deux bobines émettrices (125, 130) qui forment des champs magnétiques superposés,
une bobine réceptrice (135) située au niveau des deux champs magnétiques,
un dispositif de commande (110-120, 145-160) qui alimente les bobines émettrices (125, 130) en tensions alternatives de telle sorte que l'amplitude d'une tension synchronisée par rapport aux tensions alternatives et induite dans la bobine réceptrice (135) soit minimisée,
**caractérisé en ce que**
le dispositif de commande (110-120, 145-160) est conçu pour détecter l'objet métallique (210) lorsque le rapport entre les tensions alternatives ne correspond pas au rapport entre les distances entre la bobine réceptrice (135) et les bobines émettrices (125, 130).

2. Dispositif de mesure (100) selon la revendication 1, **caractérisé en ce que** les tensions alternatives sont des tensions alternatives déphasées l'une par rapport à l'autre qui modifient périodiquement l'amplitude et la phase des champs magnétiques des bobines émettrices (125, 130).

3. Dispositif de mesure (100) selon les revendications 1 ou 2, **caractérisé en ce que** la bobine réceptrice (135) est disposée symétriquement entre les bobines émettrices (125, 130).

4. Dispositif de mesure (100) selon la revendication 3, **caractérisé par** au moins une autre bobine réceptrice (310) disposée au niveau des champs magnétiques des bobines émettrices (125, 130), le dispositif de commande (110-120, 145-160) étant conçu pour réaliser l'alimentation des bobines émettrices (125, 130) en tensions alternatives sur la base de la tension induite dans la bobine réceptrice (135) et dans l'autre bobine réceptrice (310).

5. Dispositif de mesure (100) selon la revendication 4, **caractérisé en ce qu'**il présente un dispositif d'évaluation qui détermine la direction, la distance et la taille de l'objet métallique (210) sur la base des tensions induites dans les bobines réceptrices (135, 310).

6. Dispositif de mesure (100) selon l'une des revendications précédentes, **caractérisé en ce qu'**au moins l'une des bobines (125, 130, 135) est une bobine à entrefer d'air.

7. Dispositif de mesure (100) selon l'une des revendications précédentes, **caractérisé en ce qu'**au moins l'une des bobines (125, 130, 135) est configurée comme circuit imprimé sur une carte de circuit.

8. Dispositif de mesure (100) selon la revendication 7, **caractérisé en ce que** le dispositif de commande (110-120, 145-160) est formé sur la carte de circuit.

9. Procédé (400) de détection d'un objet métallique (210), le procédé comportant les étapes suivantes :
formation (410) de champs magnétiques superposés au moyen de deux bobines émettrices (125, 130),
détermination (420) de la tension induite dans une bobine réceptrice (135) au niveau des deux champs magnétiques,
alimentation (430) des bobines émettrices (125, 130) par des tensions alternatives de telle sorte que l'amplitude d'une tension synchronisée par rapport aux tensions alternatives et induite dans la bobine réceptrice (135) soit minimisée et
détection (440) de l'objet métallique (210) lorsque le rapport entre les tensions alternatives ne correspond pas au rapport entre les distances de la bobine réceptrice (135) et les bobines émettrices (125, 130).

10. Produit de programme informatique doté de moyens de code de programme permettant de mettre en oeuvre le procédé selon la revendication 9 lorsque le produit de programme informatique est exécuté sur un dispositif de traitement ou est conservé en mémoire sur un support de données lisibles par ordinateur.
